# EUROPÄISCHE PATENTSCHRIFT

(11) **EP 0 703 500 B1**
(45) Veröffentlichungstag und Bekanntmachung des Hinweises auf die Patenterteilung: **29.12.1999**
(21) Anmeldenummer: 95114627.3
(22) Anmeldetag: 18.09.1995
(51) Int. Cl.: G03F 7/34, B41N 3/03

(54) **Verfahren zur Herstellung einer Flachdruckform**
Process for the manufacture of a planographic printing form
Procédé pour la fabrication d'une plaque lithographique

(30) Priorität: 26.09.1994 DE 4434278
(43) Veröffentlichungstag der Anmeldung: 27.03.1996
(73) Patentinhaber: Agfa-Gevaert AG, 51373 Leverkusen (DE)
(72) Erfinder: Frass, Werner, Dr., D-65207 Wiesbaden (DE); Platzer, Stephan, Dr., Califon, N.J. 07830 (US); Gries, Willi-Kurt, Dr., D-65183 Wiesbaden (DE)

(56) Entgegenhaltungen:
- EP-A- 0 568 841
- EP-A- 0 650 094
- DE-A- 2 631 072
- DE-A- 2 725 762
- GB-A- 1 090 663
- US-A- 3 469 983

## Beschreibung

Die Erfindung betrifft ein Verfahren zur Herstellung von Flachdruckformen, bei dem man ein lichtempfindliches Material aus einem für den Flachdruck geeigneten Schichtträger, einer photopolymerisierbaren Schicht und einer transparenten, mit einer für aktinisches Licht undurchlässigen Belichtungsmaske versehenen Deckfolie durch die Belichtungsmaske mit aktinischem Licht belichtet und die photopolymerisierbare Schicht zum Bild entwickelt.

Ein Verfahren der angegebenen Gattung ist aus der EP-A 0 568 841 bekannt. Danach wird auf die Oberfläche einer lichtempfindlichen Schicht oder einer darüber befindlichen Deckfolie durch Ink-Jet-Verfahren eine Belichtungsmaske aufgebracht und die photopolymerisierbare Schicht durch die Belichtungsmaske belichtet. Die Entwicklung erfolgt durch Auswaschen oder Betonern der unbelichteten Schichtbereiche; als weitere Möglichkeiten werden Erwärmen, Ammoniakbehandlung, peel-apart-Entwicklung, Diffusionsübertragung, Farbkupplung und dgl. erwähnt, ohne daß nähere Angaben gemacht werden.

In der EP-A 0 530 674 wird ein lichtempfindliches Material beschrieben, das zwischen dem Schichtträger und der photopolymerisierbaren Schicht eine Zwischenschicht aus einem hydrophilen Polymeren (z. B. Polyvinylalkohol) und einer polymerisierbaren Verbindung trägt. Bei der Belichtung unter einer Vorlage nimmt die polymerisierbare Verbindung an der Polymerisation der photopolymerisierbaren Schicht teil und sorgt für eine erhöhte Haftung zwischen diesen Schichten. Die Entwicklung erfolgt durch mechanische Trennung von Schichtträger und Deckfolie, wobei die belichteten Schichtbereiche auf dem Schichtträger verbleiben. Die mit diesem Material erhaltenen Druckplatten ergeben keine befriedigenden Druckauflagen.

In der WO-A 93/5446 wird ein Material beschrieben, das dem vorstehend beschriebenen ähnlich ist und in gleicher Weise verarbeitet wird, aber eine hydrophile photopolymerisierbare Zwischenschicht mit einem relativ hohen Anteil an Monomeren und an Photoinitiator enthält. Hier unterliegt die Zwischenschicht der Gefahr einer ungewollten teilweisen Polymerisation, wenn sie bei der Verarbeitung nach der Bildbelichtung am Tageslicht gehandhabt wird. Hierbei kann ohne besondere Vorsichtsmaßnahmen leicht eine Polymerisation und damit Oleophilierung an den Nichtbildstellen eintreten, die beim Flachdruck zum Tonen führt.

Das in der DE-A 26 31 072 offenbarte Aufzeichnungsmaterial für die Herstellung von Flachdruckplatten umfaßt einen hydrophilen Träger, eine Schicht aus einem hydrophilen organischen Polymer, eine lichtempfindliche Schicht und einen transparenten Deckfilm. Bei der Herstellung der Druckplatte wird das Material durch eine Filmvorlage hindurch belichtet. Entwickelt wird anschließend durch Abziehen der Deckfolie. Je nach der Stärke der Haftungskräfte bleiben dabei die belichteten bzw. den unbelichteten Bereiche der lichtempfindlichen Schicht an der Deckfolie haften und werden mit entfernt.

In dem durch ein peel-apart-Verfahren, d.h. trocken entwickelbaren Aufzeichnungsmaterial zur Herstellung von Offsetdruckplatten gemäß DE-A 27 25 762 besteht die hydrophile Zwischenschicht aus wasserlöslichen, anorganischen Oxosäuren oder deren Salzen.

In der nicht vorveröffentlichten deutschen Patentanmeldung P 43 36 115.3 wird ein lichtempfindliches Material zur Herstellung von Flachdruckplatten beschrieben, das auf einem Schichtträger eine hydrophile Schicht aus einem vernetzbaren oder einem vernetzten organischen Polymeren, eine photopolymerisierbare Schicht und eine transparente Deckfolie trägt. Das Material wird im Kontakt unter einer Vorlage oder durch gesteuerte Laserstrahlung belichtet und durch Auseinanderziehen ("peel apart") von Deckfolie und Schichtträger entwickelt.

In der nicht vorveröffentlichten deutschen Patentanmeldung P 44 15 607.3 wird ein sonst gleiches lichtempfindliches Material beschrieben, dessen hydrophile Schicht ein organisches Polymeres und eine radikalisch polymerisierbare Verbindung enthält und ein Schichtgewicht im Bereich von 0,001 bis 1 g/m² hat. Die Verarbeitung erfolgt in gleicher Weise wie bei dem vorstehend beschriebenen Material.

Aufgabe der Erfindung war es, ein Verfahren zur Herstellung von Flachdruckformen vorzuschlagen, bei dem ein lichtempfindliches Material einer Bildbelichtung ohne Verwendung einer Kontaktkopiervorlage unterworfen und ohne Anwendung von Lösungen oder Chemikalien zu einer Druckform mit hoher Auflagenleistung ohne Neigung zum Tonen entwickelt werden kann.

Die Erfindung geht aus von einem Verfahren der eingangs beschriebenen Gattung.

Das erfindungsgemäße Verfahren ist dadurch gekennzeichnet, daß man ein Material einsetzt, das zwischen der photopolymerisierbaren Schicht und dem Schichtträger eine hydrophile Zwischenschicht aufweist mit einem wasserlöslichen organischen Polymer, das durch darin enthaltene funktionelle Gruppen selbst vernetzen kann oder durch ein Härtungsmittel wasserunlöslich gemacht werden kann, und dessen photopolymerisierbare Schicht beim Belichten ihre Haftung an der hydrophilen Schicht und/oder an der Deckfolie ändert, und daß man das belichtete Material durch Abziehen der Deckfolie von dem Schichtträger entwickelt und die hydrophile Zwischenschicht vernetzt oder härtet.

Gemäß einem anderen Aspekt der Erfindung wird ein lichtempfindliches Material für die Herstellung von Flachdruckformen vorgeschlagen, das auf einem für den Flachdruck geeigneten Schichtträger eine photopolymerisierbare Schicht und eine transparente Deckfolie trägt.

Das erfindungsgemäße Material ist dadurch gekennzeichnet, daß zwischen der photopolymerisierbaren Schicht und dem Schichtträger eine hydrophile Zwischenschicht angeordnet ist mit einem wasserlöslichen organischen Polymer, das durch darin enthaltene funktionelle Gruppen selbst vernetzen kann oder durch ein Härtungsmittel wasserunlöslich gemacht werden kann, daß die photopolymerisierbare Schicht so beschaffen ist, daß sie beim Belichten ihre Haftung an der hydrophilen Schicht und/oder an der Deckfolie ändert, und daß die Deckfolie eine für aktinisches Licht undurchlässige Belichtungsmaske trägt.

Die hydrophile Zwischenschicht ist für eine saubere Differenzierung der Druckform in oleophile Bild- und hydrophile Nichtbildstellen erforderlich. Vor allem verhindert sie, daß bei der peel-apart-Entwicklung Reste der oleophilen photopolymerisierbaren Schicht in den Vertiefungen der rauhen Trägeroberfläche haften bleiben und dort tonen, d. h. Druckfarbe annehmen. Die Zwischenschicht wird im allgemeinen aus einem hydrophilen, normalerweise wasserlöslichen organischen Polymeren gebildet, das zweckmäßig durch Vernetzung oder durch Polymerisation einer darin enthaltenen polymerisierbaren Verbindung unlöslich gemacht wird. Die Unlöslichkeit sollte jedenfalls zum Zeitpunkt des Druckens bewirkt sein, um ein Unterwaschen der Bildelemente durch das Feuchtwasser zu vermeiden.

Geeignete Zwischenschichten werden z. B. durch Härten von wasserlöslichen Schichten erhalten, die ein wasserlösliches Polymeres und ein Härtungsmittel enthalten. Das Härtungsmittel kann eine Verbindung sein, die mit dem Polymeren unter Vernetzung reagiert, oder eine mehrfach ungesättigte polymerisierbare Verbindung, die zu einem hochpolymeren vernetzten Produkt polymerisiert, das das wasserlösliche Polymere einschließt und unlöslich macht. Die PolymerNernetzer-Kombinationen können bevorzugt thermisch vernetzt werden; die Polymerisation kann vor allem radikalisch unter Bestrahlung initiiert werden.

Zur Erzeugung der hydrophilen Schicht geeignete vernetzbare hydrophile Polymere sind von C.L. McCormick, J.Bock und D.N.Schulz in Encyclopedia of Polymer Science and Engineering 17, 730 (1985) beschrieben. Je nach den in den Polymeren enthaltenen funktionellen Gruppen kann die Vernetzung bereits allein mit diesen Polymeren, z. B. durch Erwärmen, erreicht werden. Häufig ist es vorteilhaft, nieder- oder hochmolekulare organische oder anorganische Vernetzer einzusetzen. Auch können zur Beschleunigung der Reaktion Vernetzungskatalysatoren zugesetzt werden.

Beispiele für geeignete wasserlösliche vernetzbare Polymere sind Nucleotide, Polypeptide, Polysaccharide, Polyacrylamide, Polyethylenoxide, Polyvinylalkohole, deren Copolymere oder Pfropf-Copolymere sowie die durch polymeranaloge Umsetzung erhaltenen wasserlöslichen Derivate solcher Polymere. Auch ionisierbare Polymere, wie Polyamine, Polyimine, Polyvinylpyridine, Polyvinylpyrrolidone, Poly(meth)acrylsäuren, Polysulfon- und Polyphosphonsäuren, können eingesetzt werden. Ferner können die in den DE-A 40 23 269 und 40 23 268 beschriebenen amphoteren Acrylat-Copolymeren mit Vorteil verwendet werden. Bevorzugte Polymere sind solche mit Vinylalkohol-, Vinylpyrrolidon- und (Meth)acrylsäureeinheiten.

Geeignete Vernetzer sind wasserlösliche mehrwertige Verbindungen, die erst bei erhöhter Temperatur mit dem Polymeren reagieren, z. B. mehrwertige Alkohole wie Glykole oder Oligoglykole, Glycerin, Trimethylolethan oder -propan, Pentaerythrit, mehrwertige Aldehyde wie Glyoxal oder Glutaraldehyd; mehrwertige Säuren wie Oxalsäure, Citronensäure; Oxosäurederivate des Bors, Aluminiums, Siliciums, Phosphors oder Chroms; oder mehrwertige Amine wie Ethylendiamin, Oligo-ethylenoligoamine oder Polyethylenimine.

Als Vernetzungskatalysatoren sind hauptsächlich Säuren oder Basen, z. B. p-Toluolsulfonsäure, Schwefelsäure, Natronlauge, tertiäre Amine oder quaternäre Ammoniumbasen geeignet.

Anstelle des Vernetzers kann die Schicht auch eine radikalisch polymerisierbare Verbindung in kleinerer Menge enthalten. Diese Verbindung enthält eine oder bevorzugt zwei oder mehrere polymerisierbare ethylenische Doppelbindungen. Geeignet sind vor allem hydrophile Ester oder Amide von (Meth)acryl-, Malein-, Fumar- oder Vinylphosphonsäure. Besonders Ester der Acryl- oder Methacrylsäure mit mehrwertigen aliphatischen Alkoholen, z.B. Glykolen, Oligoglykolen, Glycerin, Diglycerin, Trimethylolethan, Trimethylol-propan, Pentaerythrit, Dipentaerythrit, die vorzugsweise nur teilweise verestert und ggf. durch Umsetzen mit Ethylen- oder Propylenglykol verlängert sind, können mit Vorteil eingesetzt werden. Ebenso sind Amide der genannten ungesättigten Säuren geeignet.

Der Mengenanteil an Polymeren liegt bevorzugt zwischen 50 und 95, der an polymerisierbarer Verbindung zwischen 5 und 50 Gew.-%. Der Vernetzer liegt im allgemeinen in einem Mengenanteil von 1 bis 30 Gew.-% vor.

Das Schichtgewicht der hydrophilen Schicht (b) beträgt vorzugsweise 0,01 bis 1, besonders bevorzugt 0,05 bis 0,5 g/m².

Geeignete Schichten sind u. a. in den älteren deutschen Patentanmeldungen P 43 36 115.3 und P 44 15 607.3 beschrieben.

Die Erzeugung der Belichtungsmaske auf der transparenten Deckfolie erfolgt bevorzugt durch digitale Bebilderung, z. B. durch einen computergesteuerten Laserdrucker oder durch anderweitige Erzeugung eines im aktinischen Bereich absorbierenden Farb- oder Tonerbilds. Hierfür geeignete Geräte sind "non-impact"-Drucker, die eine berührungslose Farb- oder Tonerübertragung ermöglichen. Geeignete Druckverfahren werden z. B. von W.E. Haas in "Imaging Processes and Materials" (Herausgeber: J.Sturge, V. Walwarth und A. Shepp), S. 375 ff, Nostrand Reinhold, N.Y. 1989, beschrieben. Geeignet sind die unter der Sammelbezeichnung Laserdrucker zusammengefaßten elektrophotographischen Ausgabeeinheiten, Ink-Jet- und Thermotransfer- bzw. Thermosublimationssysteme. Als Toner-, Tinten- und Farbbandmaterialien werden die für den jeweiligen Gerätetyp empfohlenen Standards zur Erzeugung von Schwarz-Weiß-Abbildungen auf Papier oder Folie angewendet. Zur Verbesserung der Haftung kann die Oberfläche der Deckfolie vorbehandelt werden. Besonders beim Bedrucken mittels Ink-Jet-Verfahren ist es zweckmäßig, eine zusätzliche Schicht zur Regulierung der Verdunstungsgeschwindigkeit flüchtiger Bestandteile der Druckfarbe aufzubringen. Die Erzeugung einer Belichtungsmaske durch direkte Betonerung ist z. B. in der US-A 4 429 027 beschrieben. Die Belichtungsmaske wird grundsätzlich auf die äußere (freie) Oberfläche der Deckfolie aufgebracht.

Unterhalb der transparenten Deckfolie befindet sich die photopolymerisierbare Schicht. Diese photopolymerisierbare Schicht enthält in an sich bekannter Weise als wesentliche Bestandteile
(1) ein polymeres Bindemittel,
(2) eine radikalisch polymerisierbare Verbindung und
(3) eine Verbindung oder eine Verbindungskombination, die unter der Einwirkung von aktinischer Strahlung die Polymerisation der Verbindung (2) einzuleiten vermag.

Das Bindemittel (1) muß mit den übrigen Bestandteilen kompatibel sein, d. h., über den gesamten Temperaturbereich von Herstellung und Anwendung darf keine Phasentrennung innerhalb der Schicht auftreten. Weiterhin ist es erforderlich, daß je nach Ausführungsform (Positiv- oder Negativ-Typ) entweder die unbelichteten oder die belichteten Schichtstellen eine größere Haftung zur Deckfolie als zum Schichträger aufweisen. Umgekehrt sollten die belichteten bzw. unbelichteten Bereiche stärker am Schichtträger als an der Deckfolie haften. Geeignete Polymere sind z. B. chlorierte Polyolefine (wie chlorierte Polyethylene oder chlorierte Polypropylene), Poly(meth)acrylsäureester, Polyacrylnitril, Polystyrol, Polyvinylchlorid, Polyvinylidenchlorid, Polybutadien, Polyisopren, Polychloropren, chlorierte Naturkautschuke, Polyvinylacetate, Polyvinylacetale, Polyester, Polyamide und Polyurethane sowie die Copolymeren der diesen Polymeren zugrundeliegenden Monomeren. Bevorzugt verwendet werden chlorierte Naturkautschuke, Poly(meth)acrylate und deren Copolymere sowie Polyamide. Ebenfalls bevorzugt eingesetzt werden Vertreter aus der Klasse der Polyvinylacetale, besonders der Polyvinylbutyrale. Der Bindemittelanteil in der Photopolymerschicht bewegt sich zwischen 10 und 90, besser jedoch zwischen 20 und 70 %, jeweils bezogen auf das Gewicht der nichtflüchtigen Bestandteile, d. h. der Bestandteile der Schicht, die beim Verdampfen des Lösemittels bei Temperaturen bis zu etwa 120 °C zurückbleiben.

Bei der radikalisch polymerisierbaren Verbindung (2) handelt es sich um eine ethylenisch ungesättigte Substanz oder ein entsprechendes Substanzgemisch, vorzugsweise Ester bzw. Amide der Acryl-, Methacryl-, Fumar- oder Maleinsäure. Bevorzugt sind Vertreter mit mehr als einer polymerisierbaren Doppelbindung, z.B. die Ester der genannten Säuren mit Alkandiolen, (Poly/Oligo)ethylenglykolen, (Poly/Oligo)propylenglykolen, (Poly/Oligo)butylenglykolen, und anderen nieder- oder höhermolekularen organischen Diolen. Besonders geeignet sind die Ester von mehrwertigen Alkoholen, wie Glycerin, Trimethylolethan bzw. -propan, Pentaerythrit, Isocyansäure, deren ethoxylierten oder propoxylierten Derivaten, sowie der Dimeren oder Oligomeren dieser Verbindungen. Ein möglichst hoher Veresterungsgrad ist dabei vorteilhaft. Ebenfalls verwendbar sind Amide, z. B. die Verbindungen, die formal bei der Umsetzung von Ethylendiamin oder dessen Oligomeren mit den beschriebenen Säuren entstehen. Der Mengenanteil der Monomeren liegt bei etwa 5 bis 80, bevorzugt bei etwa 10 bis 60 Gew.-% der nichtflüchtigen Bestandteile.

Als Photoinitiatoren (3) kommen je nach gewünschtem Sensibilisierungsbereich unterschiedliche Materialien zum Einsatz. Soll das lichtempfindliche Material für den im Offset-Druck üblichen nahen UV-Bereich (350 - 420 nm) empfindlich sein, so werden andere Photoinitiator-Systeme verwendet als wenn im sichtbaren Spektralbereich belichtet werden soll.

Beispiele sind Acyloine und deren Derivate wie Benzoin, Benzoinalkylether, vicinale Diketone und deren Derivate, z.B. Benzil, Benzilacetale wie Benzildimethylketal, Fluorenone, Thioxanthone, Mehrkernchinone, Acridine und Chinoxaline, ferner Trichlormethyl-s-triazine, 2-Halogenmethyl-4-vinyl-1,3,4-oxadiazolderivate, mit Trichlormethylgruppen substituierte Halogenoxazole, Trihalogenmethylgruppen enthaltende Carbonylmethylenheterocyclen und Acylphosphinoxid-Verbindungen. Die Photoinitiatoren lassen sich auch in Kombination miteinander oder mit Coinitiatoren bzw. Aktivatoren verwenden, z. B. mit Michlers Keton und seinen Derivaten oder 2-Alkylanthrachinonen. Bei den im sichtbaren Bereich eingesetzten Photoinitiatoren kommen meist Gemische aus Metallocenen, photoreduzierbaren Farbstoffen, photolytisch spaltbaren Verbindungen mit Trihalogenmethyl-Gruppen und ggf. weiteren Initiator- und Farbstoffbestandteilen in Frage, wie sie z. B. in der EP-A 0 364 735 beschrieben sind. Die Metallocen-Komponente besteht aus verschiedenartig substituierten Cyclopentadienyl-Komplexen des Titans oder Zirkoniums. Als photoreduzierbare Farbstoffe können Xanthen-, Benzoxanthen-, Benzothioxanthen-, Thiazin-, Pyronin-, Porphyrin- oder Acridin-Farbstoffe verwendet werden. Bei den Trihalogenmethyl-Coinitiatoren haben sich besonders die bekannten Triazin-Derivate mit Brom oder Chlor als Halogen bewährt. Weitere Initiatorbestandteile sind Verbindungen, die die Empfindlichkeit vor allem in nahen UV-Bereich steigern, z. B. Acridin-, Phenazin- oder Chinoxalin-Derivate, oder die eine Empfindlichkeitssteigerung im sichtbaren Bereich bewirken, z. B. Dibenzalacetone oder Cumarine.

Die Menge des Photoinitiators bzw. der Initiator-Kombination beträgt im allgemeinen etwa 0,1 bis 15 Gew.-%, bevorzugt etwa 0,5 bis 10 Gew.-% der nichtflüchtigen Schichtbestandteile.

Die photopolymerisierbare Schicht kann darüber hinaus Stabilisatoren zur Unterdrückung von thermischer Polymerisation, Pigmente, Farbstoffe, Weichmacher oder andere Hilfsstoffe zur Verbesserung von mechanischer oder reprographischer Qualität enthalten.

Die Schichtdicke der photopolymerisierbaren Schicht, ausgedrückt durch das Schichtgewicht, beträgt 0,1 bis 10 g/m², vorzugsweise 0,5 bis 5,0 g/m².

Als flexible transparente Deckfolien für das lichtempfindliche Material sind insbesondere solche Kunststoffolien geeignet, die beim Erwärmen auf etwa 60 bis 130 °C maßbeständig sind. Hierfür kommen z. B. Folien aus Celluloseacetat, Polystyrol, Polyamiden, Polycarbonaten, Polyestern und Polyimiden in Betracht. Die Folie sollte vorzugsweise für Luftsauerstoff wenig durchlässig sein. Deshalb werden vorzugsweise Folien aus Polyestern, Polycarbonaten, Polyimiden und ähnlichen Polymeren eingesetzt; Polyesterfolien werden im allgemeinen bevorzugt. Die Deckfolie kann eine Dicke im Bereich von etwa 20 bis 100, vorzugsweise 30 bis 70 µm aufweisen. Zur Verbesserung der Maßbeständigkeit werden die Folien im allgemeinen biaxial verstreckt und ggf. thermofixiert. Zur Verbesserung der Haftung der photopolymerisierbaren Schicht kann die Oberfläche einer die Haftung erhöhenden Behandlung unterworfen werden, z. B. durch Coronaentladung, durch Ätzen mit Chemikalien (z.B. Trichloressigsäure) und durch Beschichten mit einer haftvermittelnden Unterschicht. Derartige Beschichtungen sind im allgemeinen 0,001 bis 0,1 µm dick. Sie können aus Copolymeren von (Meth)acrylsäureestern bestehen (vgl. US-A 4 098 952) und vorzugsweise vernetzt sein. Geeignete Folien sind in der US-A 5 049 476 beschrieben. Die äußere Oberfläche der Folie kann einer das Blocken verhindernden Behandlung unterworfen werden, z.B. durch Beschichten mit einer geeigneten Unterschicht, die feinteilige organische oder insbesondere anorganische Partikel enthält, deren Größe, Menge und Brechungsindex so bemessen sind, daß die Transparenz der Folie nicht beeinträchtigt ist. Die Oberfläche kann glatt oder mattiert sein. Entsprechende Folien sind z. B. in der EP-A 0 130 222 beschrieben.

Der Schichtträger ist eine als Trägermaterial für Flachdruckplatten übliche metallische Platte mit hydrophiler Oberfläche. Als Metall wird Aluminium bevorzugt, das insbesondere oberflächlich aufgerauht und anodisch oxydiert ist. Die Oberfläche kann weiterhin in bekannter Weise mit Alkalisilikaten, Phosphaten, Hexafluorozirkonaten, Polyvinylphosphonsäure oder anderen üblichen Vorbehandlungsmitteln behandelt worden sein. Die Dicke des Schichtträgers liegt im allgemeinen zwischen 0,05 und 1, vorzugsweise zwischen 0,1 und 0,5 mm.

Die Herstellung des lichtempfindlichen Materials erfolgt in der Weise, daß die Bestandteile der hydrophilen Zwischenschicht in einem geeigneten Lösemittel, i. a. Wasser oder einem Gemisch von Wasser und damit mischbaren organischen Lösemitteln, wie niederen Alkanolen, Aceton oder dgl. gelöst und auf die Oberfläche des Schichtträgers in der Weise aufgebracht werden, daß nach dem Trocknen die gewünschte Schichtdicke erhalten wird. Auf die getrocknete Zwischenschicht wird dann die photopolymerisierbare Schicht in der Regel ebenfalls durch Beschichten aus einer Lösung aufgebracht. Das Lösemittel wird dabei so gewählt, daß die hydrophile Zwischenschicht nicht angelöst wird. Auf die photopolymerisierbare Schicht wird dann durch Laminieren die mit der Belichtungsmaske versehene Deckfolie aufgebracht. Das Laminieren kann bei Raumtemperatur oder bei erhöhter Temperatur erfolgen.

Das erhaltene lichtempfindliche Material wird durch die transparente Deckfolie mit der Belichtungsmaske hindurch belichtet. Durch die bildmäßige Vernetzung der photopolymerisierbaren Schicht wird deren Haftung gegenüber der Deckfolie und bzw. oder der hydrophilen Zwischenschicht verändert, so daß beim Abziehen der Deckfolie entweder die belichteten oder die unbelichteten Schichtbereiche mit dieser entfernt werden. Im ersten Fall verbleibt ein positives, im zweiten Fall ein negatives Bild auf dem Schichtträger. Die Steuerung des Haftverhaltens, die entweder ein positives oder ein negatives Bild ergibt, läßt sich mit grundsätzlich bekannten Mitteln erreichen. Da allgemein die Haftung der photopolymerisierbaren Schicht gegenüber der rauhen Oberfläche des Schichtträgers, die durch die relativ dünne hydrophile Schicht nicht eingeebnet wird, stärker ist als gegenüber der transparenten Deckfolien, sollte diese Folie in der Regel eine haftverstärkende Oberflächenbehandlung erfahren, wie es oben beschrieben ist. In den meisten Fallen bewirkt die Photopolymerisation eine Erhöhung der Haftung der photopolymerisierbaren Schicht an der rauhen, von der hydrophilen Zwischenschicht bedeckten Oberfläche des Schichtträgers. Eine Änderung dieses Verhaltens läßt sich sowohl durch Änderung der Zusammensetzung, insbesondere der Art des Bindemittels und der polymerisierbaren Verbindung, der photopolymerisierbaren Schicht und der hydrophilen Schicht erreichen. So wird in vielen Fällen mit hydrophilen Schichten, deren Hydrophilie auf der Anwesenheit von OH-Gruppen beruht, die Haftung an der Grenzfläche zur photopolymerisierbaren Schicht durch Belichten derart verändert, daß ein negatives Bild erhalten wird. In anderen Fällen, in denen die hydrophile Schicht z. B. Carboxylgruppen oder andere Säuregruppen enthält, werden häufig Positive erhalten. Im allgemeinen hat die Natur der photopolymerisierbaren Schicht einen größeren Einfluß auf das Kopierergebnis. So werden mit Schichten, die übliche Radikalinitiatoren und Bindemittel auf Basis von (Meth)acrylatpolymeren enthalten, vorwiegend negative Kopien, dagegen mit Schichten, die Polyvinylacetale als Bindemittel und solche Initiatoren enthalten, die bei Belichtung Säuren bilden, in der Regel positive Kopien erhalten. Möglichkeiten zur Beeinflussung des Haftverhaltens sind bekannt und u. a. in dem Artikel "Photosensitive Materialis by Peel-off Development" von T. Ikeda, T. Yamaoka und T. Tsunoda in Graphic Arts Japan, Vol. 21 (1979-1980), Seiten 26 - 31, beschrieben.

Nach der Bildentwicklung zum Negativ kann das auf dem Schichtträger verbliebene Bild aus gehärteten Schichtbereichen zur Erhöhung der Auflagenstabilität beim Druck in an sich bekannter Weise thermisch nachgehärtet bzw. eingebrannt werden. Bei der Herstellung von Positivdruckplatten, bei denen auf dem Schichtträger die unpolymerisierten Schichtbereiche zurückbleiben, ist es in der Regel notwendig, die Druckschablone durch Erhitzen und bzw. oder Nachbelichten zu härten. Die fertige Druckform kann vorteilhaft in üblicher Weise durch Überziehen mit einer wäßrigen Lösung eines Polymeren konserviert werden.

Durch das erfindungsgemäße Verfahren wird erreicht, daß man Flachdruckplatten durch eine Verarbeitung erhält, zu der keine flüssigen Entwickler oder andere Verarbeitungslösungen erforderlich sind. Da auch die "in situ" hergestellte Kopiervorlage keine Verarbeitung mit Chemikalien erfordert, ist bei dem erfindungsgemäßen Verfahren der gesamte Prozeß der Druckformherstellung ohne Einsatz von Chemikalien oder Verarbeitungslösungen möglich.

Die folgenden Beispiele beschreiben bevorzugte Ausführungsformen der Erfindung. Die Mengen der Bestandteile sind zumeist in Gewichtsteilen (Gt) angegeben. Mengenverhältnisse und Prozentangaben sind, wenn nichts anderes angegeben ist, in Gewichtseinheiten zu verstehen.

### Beispiel 1

Eine 0,3 mm dicke Aluminiumplatte, die elektrolytisch aufgerauht und zu einem Oxidschichtgewicht von 3,6 g/m² anodisch oxydiert worden war, wurde mit einer Lösung der folgenden Zusammensetzung beschichtet:

| | |
|---|---|
| 19,0 Gt | einer 40 %igen wäßrigen Lösung eines Acrylharzes (Röhm GmbH, Acrytex W 240), |
| 4,8 Gt | Trimethylolpropan, |
| 0,24 Gt | p-Toluolsulfonsäure und |
| 576 Gt | einer 0,1 %igen wäßrigen Lösung des Dinatriumsalzes einer n-Decyl-diphenylether-2,2'-disulfonsäure |

und zu einer Schicht von 0,3 g/m² getrocknet. Die derart vorbeschichtete Aluminiumplatte wurde anschließend mit einer Lösung der folgenden Zusammensetzung beschichtet:

| | |
|---|---|
| 7,0 Gt | Alkylmethacrylat-Copolymeres (Tg 80 °C; Säurezahl 5), |
| 56,0 Gt | Polyvinylbutyral (80 % Vinylbutyraleinheiten, 18 % Vinylalkoholeinheiten, 2 % Vinylacetateinheiten, Tg 72-78 °C), |
| 36,0 Gt | Pentaerythrittetraacrylat, |
| 54,0 Gt | Dipentaerythrit-pentaacrylat, |
| 3,6 Gt | 2,6-Bis-trichlormethyl-4-(4-styryl-phenyl)-s-triazin, |
| 10,8 Gt | Terephthalaldehyd, |
| 11,7 Gt | Renolblau B 2 G (C.I. 74160) und |
| 0,9 Gt | 2,6-Di-tert.-butyl-4-methylphenol in |
| 1001 Gt | Tetrahydrofuran, |
| 682 Gt | Propylenglykolmonomethylether und |
| 137 Gt | Butyrolacton |

Nach dem Trocknen betrug das Schichtgewicht 2,3 g/m².

Eine 50 µm dicke, einseitig haftvermittelte und auf der anderen Seite mit einer Antiblockausrüstung versehene Polyethylenterephthalatfolie wurde auf der Seite mit Antiblockausrüstung mittels eines Laserdruckers HP ^{(R)}Laserjet III mit verschiedenen schwarzen Testelementen bedruckt. Die bebilderte Folie wurde mit der haftvermittelten Seite unter Druck bei 90 °C auf die vorstehend beschriebene photopolymerisierbare Schicht laminiert und durch die Folie in einem Flachdruckplatten-Belichtungsrahmen mit einer 5 kW-Metallhalogenidlampe im Abstand von 110 cm 14 Sekunden belichtet. Anschließend wurde die Deckfolie von Hand in einem Winkel von 180° abgezogen, wobei die belichteten Bereiche der photopolymerisierbaren Schicht sauber zusammen mit der Deckfolie entfernt wurden, während die hydrophile Zwischenschicht und die unbelichteten Bereiche auf der Aluminiumplatte zurückblieben. Diese Bereiche wurden durch 50 Sekunden ganzflächige Belichtung und 15 Minuten Nacherhitzen der Druckplatte auf 200 °C ausgehärtet. Vor dem Nacherhitzen wurde auf die gesamte Oberfläche der Druckplatte eine wäßrige Lösung des in der hydrophilen Schicht eingesetzten Diphenyletherdisulfonats als Einbrenngummierung aufgebracht, um eine Beeinträchtigung der Hydrophilie der Nichtbildstellen durch das Nacherhitzen zu verhindern.

### Beispiel 2

Die in Beispiel 1 angegebene aufgerauhte und anodisierte Aluminiumplatte wurde mit einer wäßrigen Lösung von 0,8 % eines teilverseiften Polyethylenglykol/Vinylacetat-Pfropfpolymerisats mit der Esterzahl 150 und 0,2 % Borsäure beschichtet.

Das Schichtgewicht betrug nach 1 Minute Trocknen bei 100 °C 0,1 g/m². Auf die vorbeschichtete Aluminiumplatte wurde die folgende Lösung aufgebracht:

| | |
|---|---|
| 93,1 Gt | Polyethylmethacrylat (Tg 65 °C, Säurezahl 8), |
| 1,8 Gt | Polymethylmethacrylat (Tg 105 °C, Säurezahl <1), |
| 68,4 Gt | Trimethylolpropantriacrylat, |
| 2,7 Gt | 2-Benzyl-2-dimethylamino-1-(4-morpholino-phenyl)butan-1-on, |
| 3,24Gt | 4-Diethylamino-4'-methoxy-dibenzalaceton, |
| 9,0 Gt | Renolblau B 2 G, |
| 0,9 Gt | 2,6-Di-tert.-butyl-4-methylphenol und |
| 1,44Gt | Silikonöl in |
| 913 Gt | Butanon, |
| 88,2 Gt | Tetrahydrofuran, |
| 683 Gt | Propylenglykolmonomethylether und |
| 137 Gt | Butyrolacton. |

Nach dem Trocknen betrug das Schichtgewicht 2,3 g/m².

Wie in Beispiel 1 wurde eine Belichtungsmaske mit einem Laserdrucker erzeugt; in diesem Fall eine Negativmaske. Die bebilderte Folie wurde mit ihrer Rückseite auf die photopolymerisierbare Schicht der Druckplatte unter Druck bei 90 °C laminiert. Nach 10 Sekunden Belichtung ohne Vorlage wurde die Deckfolie zusammen mit den unbelichteten Bereichen der lichtempfindlichen Schicht abgezogen. Die auf der Aluminiumplatte verbliebenen lichtgehärteten Bereiche der photopolymerisierbaren Schicht wurden ohne weitere Behandlung zum Drucken eingesetzt.

## Patentansprüche

1. Verfahren zur Herstellung einer Flachdruckform, bei dem man ein lichtempfindliches Material aus einem für den Flachdruck geeigneten Schichtträger, einer photopolymerisierbaren Schicht und einer transparenten, mit einer für aktinisches Licht undurchlässigen Belichtungsmaske versehenen Deckfolie durch die Belichtungsmaske mit aktinischem Licht belichtet und die photopolymerisierbare Schicht zum Bild entwickelt, dadurch gekennzeichnet, daß man ein Material einsetzt, das zwischen der photopolymerisierbaren Schicht und dem Schichtträger eine hydrophile Zwischenschicht aufweist mit einem wasserlöslichen organischen Polymer, das durch darin enthaltene funktionelle Gruppen selbst vernetzen kann oder durch ein Härtungsmittel wasserunlöslich gemacht werden kann, und dessen photopolymerisierbare Schicht beim Belichten ihre Haftung an der hydrophilen Schicht und/oder an der Deckfolie ändert, daß man das belichtete Material durch Abziehen der Deckfolie von dem Schichtträger entwickelt und daß man die hydrophile Zwischenschicht vernetzt oder härtet.

2. Verfahren nach Anspruch 1, dadurch gekennzeichnet, daß man ein Material einsetzt, dessen photopolymerisierbare Schicht vor dem Belichten stärker an der hydrophilen Schicht haftet als an der Deckfolie und nach dem Belichten stärker an der Deckfolie haftet als an der hydrophilen Schicht, daß man auf die Oberfläche der Deckfolie eine positive Belichtungsmaske aufbringt und daß man die nach dem Entwickeln auf dem Schichtträger verbliebenen, nicht gehärteten Bildbereiche der photopolymerisierbaren Schicht durch Belichten und/oder Erwärmen härtet.

3. Verfahren nach Anspruch 1, dadurch gekennzeichnet, daß man ein Material einsetzt, dessen photopolymerisierbare Schicht vor dem Belichten stärker an der Deckfolie haftet als an der hydrophilen Schicht und nach dem Belichten stärker an der hydrophilen Schicht haftet als an der Deckfolie und daß man auf die Oberfläche der Deckfolie eine negative Belichtungsmaske aufbringt.

4. Verfahren nach Anspruch 1, dadurch gekennzeichnet, daß die Härtung der hydrophilen Zwischenschicht durch Vernetzung oder Polymerisation erfolgt.

5. Verfahren nach Anspruch 1, dadurch gekennzeichnet, daß das Härtungsmittel eine Verbindung ist, die mit dem Polymer der hydrophilen Zwischenschicht unter Vernetzung reagiert.

6. Verfahren nach Anspruch 4, dadurch gekennzeichnet, daß das Härtungsmittel eine mehrfach ungesättigte polymerisierbare Verbindung ist, die zu einem hochpolymeren vernetzten Produkt polymerisiert, das das wasserlösliche Polymer wasserunlöslich macht.

7. Verfahren nach Anspruch 1, dadurch gekennzeichnet, daß die hydrophile Zwischenschicht ein Schichtgewicht von 0,001 bis 1 g/m² hat.

8. Verfahren nach Anspruch 1, dadurch gekennzeichnet, daß man die für aktinisches Licht undurchlässige Belichtungsmaske mittels eines elektronisch gesteuerten Druckverfahrens aufbringt.

9. Verfahren nach Anspruch 1, dadurch gekennzeichnet, daß man die Belichtungsmaske auf der Deckfolie erzeugt und die Deckfolie danach auf die photopolymerisierbare Schicht laminiert.

10. Verfahren nach Anspruch 9, dadurch gekennzeichnet, daß man die bebilderte Deckfolie mit der Rückseite auf die photopolymerisierbare Schicht laminiert.

11. Verfahren nach Anspruch 1, dadurch gekennzeichnet, daß man ein Material einsetzt, dessen photopolymerisierbare Schicht als wesentliche Bestandteile
1) ein polymeres Bindemittel,
2) eine radikalisch polymerisierbare Verbindung und
3) eine Verbindung oder eine Verbindungskombination enthält, die unter Einwirkung von aktinischem Licht die Polymerisation der Verbindung (2) einzuleiten vermag.

12. Lichtempfindliches Material für die Herstellung von Flachdruckformen mit einem für den Flachdruck geeigneten Schichtträger, einer photopolymerisierbaren Schicht und einer transparenten Deckfolie, dadurch gekennzeichnet, daß
- zwischen der photopolymerisierbaren Schicht und dem Schichtträger eine hydrophile Zwischenschicht angeordnet ist mit einem wasserlöslichen organischen Polymer, das durch darin enthaltene funktionelle Gruppen selbst vernetzen kann oder durch ein Härtungsmittel wasserunlöslich gemacht werden kann,
- die photopolymerisierbare Schicht so beschaffen ist, daß sie beim Belichten ihre Haftung an der hydrophilen Schicht und/oder an der Deckfolie ändert, und
- die Deckfolie eine für aktinisches Licht undurchlässige Belichtungsmaske trägt.

## Claims

1. Process for the production of a planographic printing member, in which a photosensitive material comprising a layer support suitable for planographic printing, a photopolymerisable layer and a transparent cover film provided with an exposure mask opaque to actinic light is exposed through the exposure mask with actinic light and the photopolymerisable layer is developed to form the image, characterised in that a material is used which, between the photopolymerisable layer and the layer support, has a hydrophilic interlayer having a water-soluble organic polymer, which may crosslink intrinsically by functional groups contained therein or may be rendered insoluble in water by a curing agent, and the photopolymerisable layer of which changes its adhesion to the hydrophilic layer and/or to the cover film on exposure to light, in that the exposed material is developed by peeling the cover film from the layer support and in that the hydrophilic interlayer is crosslinked or cured.

2. Process according to claim 1, characterised in that a material is used, the photopolymerisable layer of which, before exposure to light, adheres more strongly to the hydrophilic layer than to the cover film and, after exposure to light, adheres more strongly to the cover film than to the hydrophilic layer, in that a positive exposure mask is applied onto the surface of the cover film and in that the uncured image areas of the photopolymerisable layer remaining on the layer support after development are cured by exposure to light and/or heating.

3. Process according to claim 1, characterised in that a material is used, the photopolymerisable layer of which, before to exposure to light, adheres more strongly to the cover film than to the hydrophilic layer and, after exposure to light, adheres more strongly to the hydrophilic layer than to the cover film and in that a negative exposure mask is applied onto the surface of the cover film.

4. Process according to claim 1, characterised in that the hydrophilic interlayer is cured by crosslinking or polymerisation.

5. Process according to claim 1, characterised in that the curing agent is a compound which reacts with the polymer of the hydrophilic interlayer with crosslinking.

6. Process according to claim 4, characterised in that the curing agent is a polyunsaturated polymerisable compound which polymerises to yield a high-polymeric crosslinked product, which renders the water-soluble polymer insoluble in water.

7. Process according to claim 1, characterised in that the hydrophilic interlayer has a weight per unit area of 0.001 to 1 g/m².

8. Process according to claim 1, characterised in that the exposure mask opaque to actinic light is applied by means of an electronically controlled printing process.

9. Process according to claim 1, characterised in that the exposure mask is produced on the cover film and the cover film is then laminated on the photopolymerisable layer.

10. Process according to claim 9, characterised in that the cover film provided with an image is laminated with the reverse side on the photopolymerisable layer.

11. Process according to claim 1, characterised in that a material is used, the photopolymerisable layer of which contains as substantial constituents
1) a polymeric binder,
2) a free-radically polymerisable compound and
3) a compound or combination of compounds which, under the action of actinic light, is capable of initiating the polymerisation of compound (2).

12. Photosensitive material for the production of planographic printing members comprising a layer support suitable for planographic printing, a photopolymerisable layer and a transparent cover film, characterised in that,
- between the photopolymerisable layer and the layer support, there is arranged a hydrophilic interlayer having a water-soluble organic polymer, which may crosslink intrinsically by functional groups contained therein or may be rendered insoluble in water by a curing agent,
- the photopolymerisable layer is of a nature such that it changes its adhesion to the hydrophilic layer and/or to the cover film on exposure to light, and
- the cover film bears an exposure mask opaque to actinic light.

## Revendications

1. Procédé de fabrication d'une plaque d'impression lithographique, selon lequel on expose à la lumière actinique à travers le masque d'exposition, un matériau photosensible constitué d'une couche support appropriée pour l'impression lithographique, d'une couche photopolymérisable et d'une feuille de couverture transparente prévue avec un masque d'exposition opaque à la lumière actinique et on développe selon une image la couche photopolymérisable, caractérisé en ce qu'on utilise un matériau qui présente entre la couche photopolymérisable et la couche support une couche intermédiaire hydrophile avec un polymère organique soluble dans l'eau, qui peut être réticulé lui-même par des groupes fonctionnels contenus dans celui-ci ou qui peut être rendu insoluble dans l'eau par un agent de durcissement, et dont la couche photopolymérisable modifie par exposition son adhérence à la couche hydrophile et/ou à la feuille de couverture, et en ce qu'on développe le matériau exposé par pelage de la feuille de couverture de la couche support et en ce qu'on réticule ou on durcit la couche intermédiaire hydrophile.

2. Procédé selon la revendication 1, caractérisé en ce qu'on utilise un matériau dont la couche photopolymérisable avant l'exposition adhère plus fortement sur la couche hydrophile que sur la feuille de couverture et après l'exposition adhère plus fortement sur la feuille de couverture que sur la couche hydrophile, en ce qu'on amène sur la surface de la feuille de couverture un masque d'exposition positif et en ce qu'on durcit par exposition et/ou chauffage les zones d'image non durcies de la couche photopolymérisable restant sur la couche support.

3. Procédé selon la revendication 1, caractérisé en ce qu'on utilise un matériau dont la couche photopolymérisable avant l'exposition adhère plus fortement sur la feuille de couverture que sur la couche hydrophile et après l'exposition adhère plus fortement sur la couche hydrophile que sur la feuille de couverture et en ce qu'on amène sur la surface de la feuille de couverture un masque d'exposition négatif.

4. Procédé selon la revendication 1, caractérisé en ce que le durcissement de la couche intermédiaire hydrophile a lieu par réticulation ou polymérisation.

5. Procédé selon la revendication 1, caractérisé en ce que l'agent de durcissement est un composé qui réagit selon une réticulation avec le polymère de la couche intermédiaire hydrophile.

6. Procédé selon la revendication 4, caractérisé en ce que l'agent de durcissement est un composé polymérisable polyinsaturé qui polymérise en un produit réticulé haut polymère qui rend insoluble dans l'eau le polymère soluble dans l'eau.

7. Procédé selon la revendication 1, caractérisé en ce que la couche intermédiaire hydrophile a un poids de couche de 0,001 à 1 g/m².

8. Procédé selon la revendication 1, caractérisé en ce qu'on amène le masque d'exposition opaque à la lumière actinique au moyen d'un procédé d'impression contrôlé électroniquement.

9. Procédé selon la revendication 1, caractérisé en ce qu'on produit le masque d'exposition sur la feuille de couverture et on stratifie ensuite la feuille de couverture sur la couche photopolymérisable.

10. Procédé selon la revendication 9, caractérisé en ce qu'on stratifie la feuille de couverture avec une image avec la face dorsale sur la couche photopolymérisable.

11. Procédé selon la revendication 1, caractérisé en ce qu'on utilise un matériau dont la couche photopolymérisable contient comme constituants essentiels
(4) un liant polymère,
(5) un composé polymérisable radicalairement et
(6) un composé ou une combinaison de composés qui sous l'action d'une lumière actinique est susceptible de déclencher la polymérisation du composé (2).

12. Matériau photosensible pour la fabrication de plaques d'impression lithographique avec une couche support appropriée pour l'impression lithographique, une couche photopolymérisable et une feuille de couverture transparente, caractérisé en ce que
- entre la couche photopolymérisable et la couche support est placée une couche intermédiaire hydrophile avec un polymère organique soluble dans l'eau qui peut être réticulé par lui-même par des groupes fonctionnels contenus dans celui-ci ou qui peut être rendu insoluble dans l'eau par un agent de durcissement,
- la couche photopolymérisable est d'une nature telle que par exposition elle modifie son adhérence sur la couche hydrophile et/ou sur la feuille de couverture, et
- la feuille de couverture porte un masque d'exposition opaque à la lumière actinique.
